Europäisches Patentamt

European Patent Office

Office européen des brevets

(19)

(11) Publication number: **0 263 574**
**A1**

(12) **EUROPEAN PATENT APPLICATION**

(21) Application number: **87304779.9**

(22) Date of filing: **29.05.87**

(51) Int. Cl.⁴: **H01L 21/90** , H01L 23/52 ,
//H01L21/268,H01L21/263

(30) Priority: **08.09.86 US 905298**

(43) Date of publication of application:
**13.04.88 Bulletin 88/15**

(84) Designated Contracting States:
**DE FR GB NL**

(71) Applicant: **INMOS CORPORATION**
**P.O. Box 16000**
**Colorado Springs Colorado 80935(US)**

(72) Inventor: **Jones, Robert Edwin**
**2722 Inspiration Drive**
**Colorado Springs Colorado 80917(US)**
Inventor: **Kammerdiner, Lee**
**39327 Harbour Road**
**Avondale Colorado 81022(US)**
Inventor: **Reeder, Michael Ray**
**6361 Georgetown Court**
**Colorado Springs Colorado 80919(US)**

(74) Representative: **Needle, Jacqueline et al**
**PAGE, WHITE & FARRER 5 Plough Place New**
**Fetter Lane**
**London EC4A 1HY(GB)**

(54) **A method of manufacturing a semiconductor device, and a semiconductor device, having at least one selectively actuable conductive line.**

(57) A method of manufacturing a semiconductor device (20) having at least one selectively actuable conductive link (34), and a semiconductor device so produced, enables circuit elements (22,24) to be closely packed on a semiconductor substrate (26). An electrically conductive semiconductor link (34) is formed to join two circuit elements (22,24), but a non-conductive region (44) within the link (34) prevents their electrical connection. The non-conductive region (44) can be amorphous such that the application of an energy beam (48) thereto recrystallizes the region (44) and activates the electrical connection. The link between the two circuit elements (22,24) can be made without bulk material movement.

FIG. 4.

FIG. 5.

## A METHOD OF MANUFACTURING A SEMICONDUCTOR DEVICE, AND A SEMICONDUCTOR DEVICE, HAVING AT LEAST ONE SELECTIVELY ACTUABLE CONDUCTIVE LINK

The present invention relates to a method of manufacturing a semiconductor device, and a semiconductor device having at least one selectively actuable conductive link.

High efficiency semiconductor chips are possible due to large concentrations of circuit elements on a single chip. However, as the number of circuit elements on a chip increase, so the probability increases that a circuit element will fail rendering the total chip unusable. To prevent such a loss, additional circuit elements have been designed into the chips. Defective circuit elements are identified and then disconnected, and selected additional spare elements are connected to produce a working chip. This ability to use additional circuit elements to reconfigure a circuit design produces a higher yield in semiconductor production. In addition, the ability to selectively disconnect or connect circuit elements on a chip or wafer can be used to provide customization where the reconfiguration of the circuit is employed to modify the function of the circuit.

Additionally, in wafer scale integration, a number of selectable integrated circuit devices are fabricated on a wafer. In general, the devices need not all be of the same type. After testing, the appropriate functional devices are electrically connected together to make the overall circuit on the wafer. Both redundancy and customization may be involved in the selection of devices and their connections. The ability to make electrical connections is a great advantage over the ability to break connections since this allows testing of the individual integrated circuit devices.

In order to remove a defective or undesired circuit element from the good or desired circuit elements, an existing conductive link joining the defective circuit element to the good circuit elements can be restructured to produce an electrically non-conductive link. The most common restructurable conductive path technique for integrated circuits is to destroy the existing link. In destructive techniques, the link (fuse) can be melted by directing a very large current through the link, or it may be vaporized by a powerful energy beam. Both the melting and vaporizing approaches produce a gap in the link which renders the link electrically nonconductive. The gap is created as a result of the high energy applied to the link which produces a movement or transport of conductive material out of the link.

Methods for activation of a spare circuit element or "writing of a conductive link" can also involve the bilk transport of conductive material. These activation methods are "mass additive" as opposed to "mass subtractive" in that material is added in to form an electrically conductive link rather than subtracted out to destroy an electrically conductive link. Such methods are described by J. Raffel, M. Naiman, R. Burke, G. Chapman, and P. Gottschalk, "Laser Programmed Vias For Restructurable VLSI," International Electron Device Meeting (IEDM), pp. 132-135 (1980); and J. Yasaitis, G. Chapman, and J. Raffel, "Low Resistance Laser Formed Lateral Links," IEEE Electron Device Letters, EDL-3, pp. 184-186 (1982).

Both the mass additive and mass subtractive techniques have several disadvantages. One disadvantage is that whenever there is forced movement of material, some portions of that material will splatter onto other areas of the chip. The splattered material can produce flaws in other circuit elements. A further disadvantage of these methods is that they require a high energy input which will destroy any passivation layer over the link and which is capable of inflicting thermal damage to surrounding circuits. As a result, these methods impose design rules which limit how close circuit elements can be placed to each other, and therefore are not beneficial in very high density semiconductor chips.

Other methods which do not require the material movement associated with mass additive and mass subtractive techniques are also known. One of these techniques requires a region of undoped polycrystalline material to serve as a link positioned between two regions of heavily doped polycrystalline material. The link of undoped material is substantially electrically nonconductive. However, a laser beam provides an energy source to activate dopant atoms from the neighboring heavily doped semiconductor regions causing them to diffuse into the undoped link. The diffused dopant atoms turn the link into an electrically conductive path joining the two heavily doped regions. This technique is described in articles by: O. Minato, T. Masuhara, T. Sasaki, Y. Sakai, and K. Yashizaki, "A High-Speed Hi-CMOS II 4K Static RAM," IEEE J. Solid-State Circuits, SC-16, pp 449-453 (1981); and M. Hongo, T. Miyauchi, H. Yamaguchi, T. Masuhara, and O. Minato, "Connecting Conductors On Semiconducting Devices by Lasers," Conference on Lasers and Electro-Optics, IEEE, p. 62 (1982).

While this technique does produce an electrically conductive link, the link still has an undesirably high resistance of 500 or more ohms. But an even greater disadvantage of this technique is the requirement that the undoped polycrystalline region remain undoped during the manufacturing process of the chip. This requires additional masking steps to protect the undoped region and prevents the use of economical doping techniques such as thermal diffusion or blanket ion implantation methods.

Another technique of laser activation of conductive links between circuit elements is described in U.S. Patent 4,462,150 to Nishimura et al. issued July 31, 1984 for "Method of Forming Energy Beam Activated Conductive Regions between Circuit Elements;" and by D.L. Parker, F. Lin, and D. Zhang, "Laser Polysilicon Link Making," IEEE Trans. on Components, Hybrids, and Manufacturing Technology, CHMT-7, pp. 438-442 (1984). This technique requires the formation of an undoped region of polycrystalline material between two doped regions of polycrystalline material. Then dopant atoms are implanted in the undoped portion and left unannealed. A laser beam can then be directed at the link region to provide the energy to anneal the region to produce a conductive link. This technique does produce links of low resistance, but to achieve a low resistance, dopant atoms must be provided in doses of $5 \times 10^{15}$ atoms/cm² or more. Further, this technique still requires the creation of an initial undoped region of polycrystalline material which necessitates more complicated doping techniques including an additional masking step.

It is an object of the present invention to provide a method of manufacturing a semiconductor device, and a semiconductor device having at least one selectively actuable conductive link, without the material splatter and circuit damage problems associated with prior art techniques.

According to the present invention, there is provided a method of manufacturing a semiconductor device having at least one selectively actuable conductive link, comprising the steps of:

forming circuit elements on a semiconductor substrate ;

forming an electrically conductive semiconductor link joining at least one said circuit element to another said circuit element;

creating a non-conductive region within said conducting link; and

selectively activating said non-conductive region with an energy beam to electrically connect said circuit elements.

With a method of the invention, it is not necessary to maintain an undoped intrinsic region of polycrystalline material. Furthermore, a relatively low ion implant dose can be used to create the non-conductive region. The non-conductive region can also be selectively activated without destruction of any passivation dielectric layer.

The present invention also extends to a semiconductor device having at least one selectively actuable link, comprising:

a semiconductor substrate;

circuit elements formed on said substrate;

a semiconductor link joining at least one circuit element to another said circuit element; and

a non-conducting region within said semiconductor link;

wherein said non-conducting region can be selectively activated by way of an energy beam to thereby electrically connect said circuit elements.

In an embodiment, during formation of an integrated circuit on a semiconductor substrate, an additional element is formed connected to another circuit element by way of an electrically conductive link comprising polysilicon, for example. A portion of that link is then bombarded with atoms which heavily damage whatever lattice structure that portion has to thereby produce a non-conductive amorphous region penetrating through the polysilicon link. This amorphous, heavily damaged region electrically separates the additional element from the circuit elements. The atoms may be neutral or, in the preferred embodiment, ions of the same conductive type as the dopant in the doped polysilicon link. The circuit elements and link are then covered with at least one layer of a dielectric material.

To establish a new electrically conductive path in the semiconductor device, an energy beam is directed through the overlying dielectric layer at the non-conductive amorphous region of the link. The energy from the beam allows the amorphized region to recrystallize the lattice and become electrically conductive thereby joining the additional element to the previously formed circuit element.

Embodiments of the present invention will hereinafter be described, by way of example, with reference to the accompanying drawings, in which:-

FIGS. IA to IG show cross-sectional segment views of a semiconductor wafer showing steps in the production of a first embodiment of a semiconductor device;

FIG. 2 shows the device of FIG. IG undergoing atom implantation;

FIG. 3 shows the device of FIG. 2 with an amorphous region and a dielectric layer over the surface of the wafer;

FIG. 4 shows the device of FIG. 3 undergoing energy beam activation of the amorphized region;

FIG. 5 shows the device of FIG. 3 after recrystallization;

FIG. 6 shows a cross-sectional view of a semiconductor wafer illustrating a second embodiment of a semiconductor device in which a metal circuit element is connected to a selected additional circuit element;

FIG. 7 shows a cross-sectional view of a semiconductor wafer illustrating a third embodiment of a semiconductor device in which two metal circuit elements are connected; and

FIG. 8 shows a cross-sectional view illustrating a further embodiment of a semiconductor device.

FIGS. IA to IG illustrate steps in the production of a first embodiment of a semiconductor device 20. FIG. IA shows a cross-section of a semiconductor wafer having first circuit element 22 and a second circuit element 24 formed in a P type substrate 26. Whilst the circuit elements are illustrated as N+ in a P type substrate, it will be understood that this is exemplary, and one could have N+ circuit elements on a P type substrate or use the same process with P+ doped circuit elements in or on an N type substrate. A first dielectric layer 28 of $SiO_2$ or other suitable material is formed over the surface of the substrate 26 and the circuit elements 22 and 24 by a conventional method such as chemical vapor deposition (CVD) or thermal growth.

Using a conventional photolithography etching technique, contact openings 30 and 32 are etched through the dielectric layer 28, as shown in FIG. IB, to expose a portion of the first circuit element 22 and of the second circuit element 24 respectively. Then, as shown in FIG. IC, a doped polysilicon film 33, connected through opening 30 to the first circuit element 22, and through opening 32 to the second circuit element 24, is formed on the layer 28 by a conventional vapor deposition process. The doping of the polysilicon film 33 can be achieved by various means including thermal diffusion from a dopant source, blanket ion implantation or in situ doping during deposition. In a preferred embodiment, the doped polysilicon film 33 is an N+ doped polycrystalline silicon.

As shown in FIG. ID, the doped polysilicon film 33 is then masked and etched to form a polysilicon link 34 between the first circuit element 22 and the second circuit element 24 which is spaced from these circuit elements by the layer 28. The link 34 is preferably 2000 angstroms thick and has a concentration of dopant atoms in the range $2 \times 10^{20}$ to $1 \times 10^{21}/cm^3$. The link 34 may range in thickness from 400 to 4000 angstroms with a concentration

range of $1 \times 10^{19}$ to $1 \times 10^{21}/cm^3$. A second dielectric layer 36 is then formed over the doped polysilicon link 34 by a conventional process such as vapor deposition or thermal growth, as illustrated in FIG. IE.

Next a masking step is done. A conventional photoresist film 38 is formed on top of the second dielectric layer 36 and patterned by a photolithography process to create an opening 39 in the film 38 over an underlying area of the link 34 between the circuit elements 22 and 24 (FIG. IF). As shown in FIG. IG, a conventional etching process is then employed to open a window 40 through the second dielectric layer 36 to expose a portion of the underlying link 34.

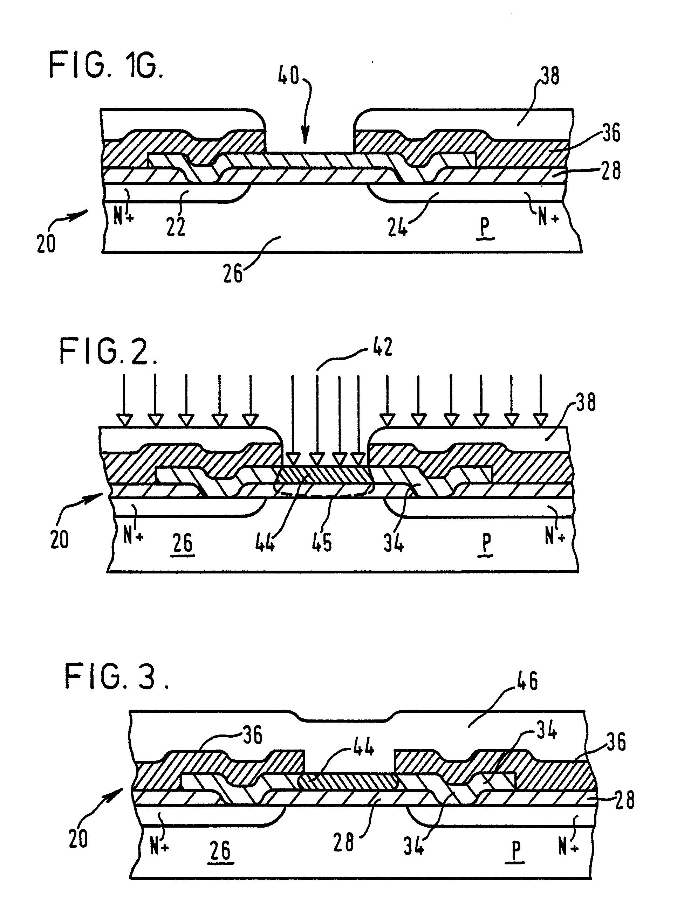

As illustrated in FIG. 2, the wafer is then exposed to a bombardment of dopant atoms 42, or the like, for the purpose of implanting dopant atoms into the exposed portion of the link 34. Whilst the photoresist layer 38 could be removed prior to the atom bombardment, in the illustrated embodiment it is left in place to provide added protection, together with the second dielectric layer 36 against the implantation of dopant atoms into areas other than the exposed portion of the link 34. The dopant atoms 42 are of a sufficient energy and dose to heavily damage the lattice of the link 34 joining the circuit element 22 to the circuit element 24. This creates a substantially non-conductive portion, hereinafter referred to as an amorphous region 44, extending through the exposed portion of the link 34 and into the layer 28 as illustrated by a dashed line 45. The amorphous region 44 penetrating the entire depth of the link layer 34 provides a region of extremely low conductivity and thus electrically separates the first circuit element 22 from the second circuit element 24.

The atom bombardment may consist of dopant ions of the same conductive type to that of the doped polycrystalline silicon layer 34, of neutral atoms, or of dopant ions of the opposite conductive type to that of the doped polycrystalline silicon, with the restriction that the implant dose should be insufficient to compensate the original dopant concentration. For example, boron or boron difluoride ions may be implanted into P+ silicon, or as in the illustrated embodiment phosphorous or arsenic ions may be implanted into N+ polycrystalline silicon. The atoms should have an energy in the range of 30 to 300 keV and be implanted in a dosage of $1 \times 10^{14}/cm^2$ to $5 \times 10^{15}/cm^2$. The dose and energy of the implant are chosen so that the amorphous region extends through the conductive link. The appropriate dose and energy depend on the type of ions implanted as well as on the thickness of the conductive link. Lighter implanted ions require a higher dose but a lower energy to achieve a required amorphous region whereas heavier implanted ions require a lower dose but a higher energy. In the illustrated embodiment for a 2000 angstrom thick N+ conductive link having $1 \times 10^{21}/cm^3$ dopant concentration, the required amorphous region can be created with a $1 \times 10^{15}/cm^2$, 100 keV implant of phosphorous ions. Averaged through the conductive link thickness, the contribution of this implant to the total concentration is less than $5 \times 10^{19}/cm^3$. A similar P+ conductive link (not shown) having an initial boron concentration of $3 \times 10^{20}/cm^3$ could have the required amorphous region created with the same dose and energy implant of phosphorous ions as is required for the N+ conductive link 34 described above. Upon recrystallization, this P+ link would return to P+ type with only a limited reduction in conductivity due to the partial compensation provided by the phosphorous ions. Thus, in an alternative embodiment having both an N+ link joining circuit elements and a P+ link joining circuit elements, a single implant step would create amorphous regions in both the N+ and the P+ conductive links on the same wafer. This eliminates the requirement for an additional masking step and an additional implant step to first create an amorphous region in one link and then to create an amorphous region in the other type link. Alternatively a 100 keV, $1 \times 10^{15}/cm^2$ implant of silicon or argon could be used to simultaneously or individually create amorphous regions in both the N+ and the P+ links.

After the creation of the amorphous region 44 in the link 34, the processing temperatures are kept below 600°C in order to prevent activation of the links. As shown in FIG. 3, the photoresist layer 38 is removed, and in the illustrated embodiment, a conventional passivation dielectric layer 46 of Phosphorous Silicon Glass (PSG) or other suitable material is then deposited on the wafer, preferably by either a conventional chemical vapor deposition process or a sputter process in order to avoid generating temperatures greater than 600°C in the amorphous region 44. The conventional passivation dielectric layer is highly preferred but not essential to make the device work.

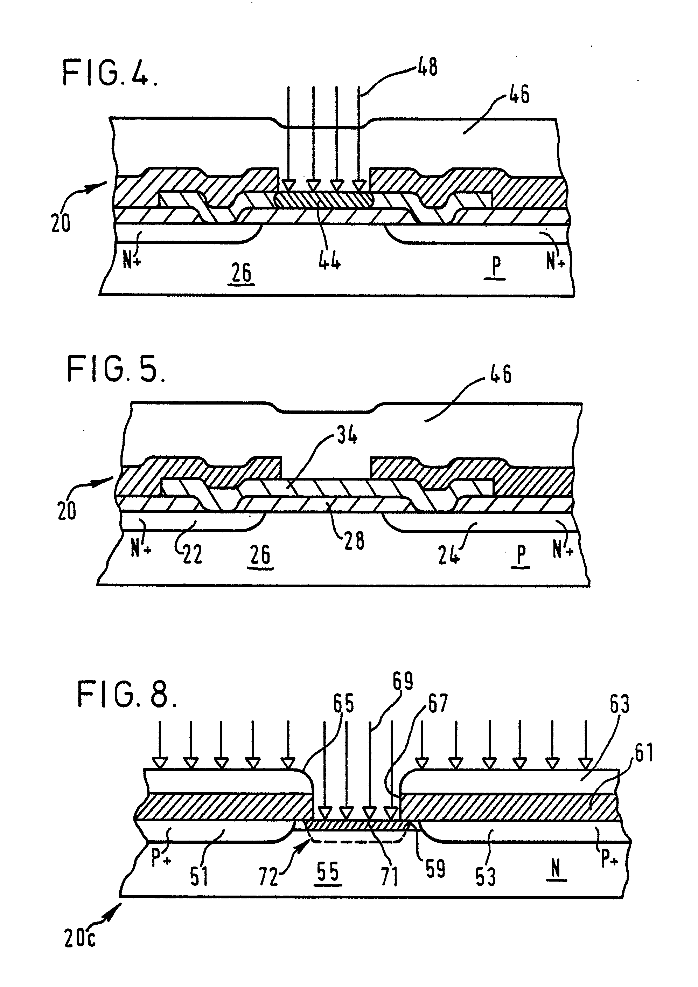

As shown in FIG. 4, the amorphous region 44 can selectively have its damaged lattice recrystallized to reform polycrystalline silicon under the influence of an energy beam 48 directed, for example, by a conventional computer-controlled aiming technique, through the passivation dielectric layer 46 onto the amorphous region 44. The energy beam 48 may be a conventional energy beam such as an electron beam or a laser. For example, in one embodiment, the energy beam 48 is a continuous wave green light laser having an energy of 0.05 to 1.0 J/cm², and having a beam width which is approximately equal to the width of the amorphous region 44. In the illustrated embodiment, the width of the amorphous region 44 is 1.0 to 4.0 micrometres.

As depicted in FIG. 4, the energy beam 48 penetrates the passivation dielectric layer 46 without causing damage to this layer 46. The energy beam 48 raises the temperature of the amorphous region 44 above 600°C and preferably above 900°C. This supplies the needed energy for recrystallization of the amorphous region and activation of the dopant. The amorphous region 44 recrystallizes at temperatures of 600°C and above by either solid phase recrystallization or local melting and resolidification. Temperatures above 900°C are beneficial in terms of obtaining better activation of the dopant atoms present in the region 44. These higher temperatures also are preferred for the more rapid recrystallization. To prevent destruction of the overlaying passivation layer, its melting temperature must not be reached, nor can the silicon reach its vaporization temperature. Depending on the materials employed, further temperature limits may be required to prevent excessive interface interactions. As the amorphous region 44 recrystallizes, the conductivity of the link 34 increases.

As shown in FIG. 5, conversion of the amorphous region 44 to polycrystalline silicon allows the link 34 to serve as an electrically conductive path between the first circuit element 22 and the second circuit element 24.

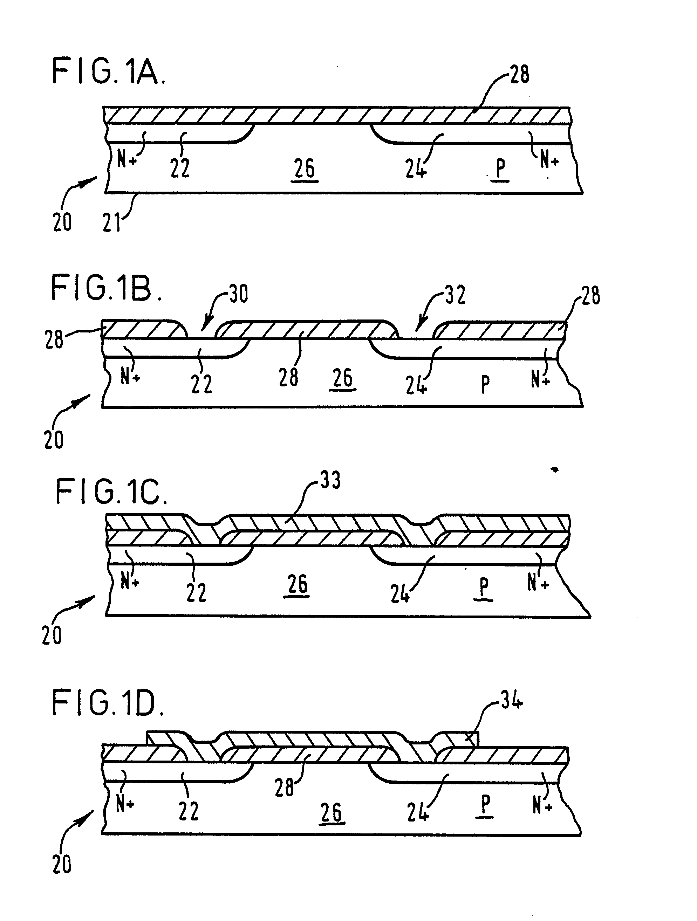

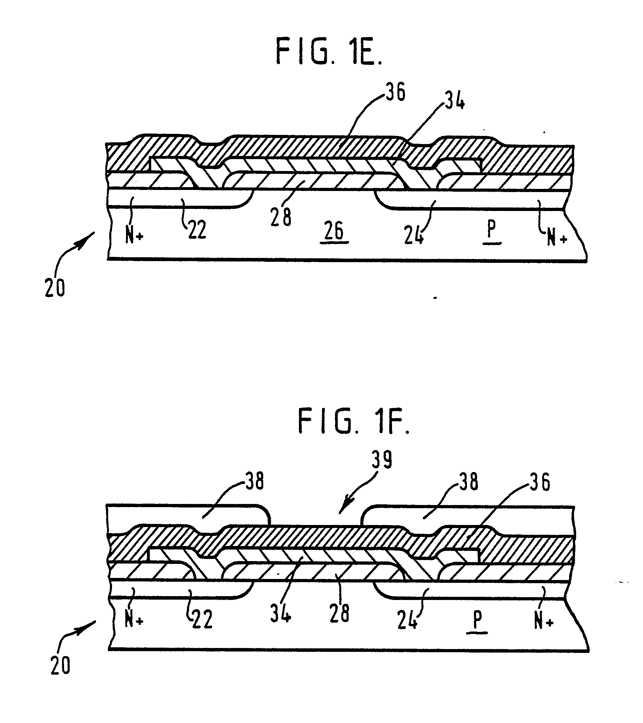

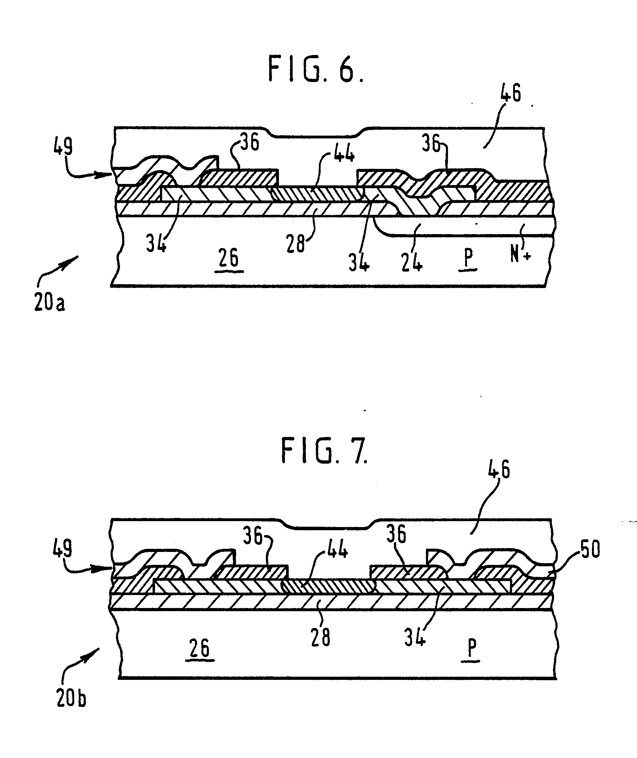

FIG. 6 illustrates a second embodiment 20a of a semiconductor device which is similar to the device illustrated in FIGS. 1A to FIG. 5 but does not include the circuit element 22. FIG. 6 shows this second embodiment at the same stage of construction as shown in FIG. 3 for the previously discussed embodiment. However, prior to forming the amorphous region 44 a window has been formed in the second dielectric layer 36 and a metal circuit element 49 has been formed to contact the link 34 through the window. Thus, the polycrystalline silicon link 34 with its amorphous region 44 connects the metal circuit element 49 to the circuit element 24 in the semiconducting substrate 26. The amorphous region 44 is then recrystallized as described above with reference to FIGS. 4 and 5.

FIG. 7 illustrates a third embodiment of a device 20b which is again a modification of the device illustrated in FIGS. 1A to FIG. 5, this further embodiment 20b omitting both the circuit elements 22 and 24. FIG. 7 shows this third embodiment at the same stage of construction as shown in FIG. 3 for the first embodiment. However, in the embodiment of FIG. 7, prior to the formation of the amorphous region 44, two windows have been formed in the second dielectric layer 36 above areas on opposite sides of the underlying link 34. The metal circuit element 49 and a second metal circuit element 50 have been formed in contact with the link 34 through the windows. The amorphous region 44 has then been formed as described above. The polycrystalline silicon link 34 with its amorphous region 44 connectes the metal circuit element 49 to the metal circuit element 50, both of which are formed in the layers above the semiconductor substrate 26. The amorphous region 44 may subsequently be recrystallized as described above with reference to FIGS. 4 and 5.

Illustratively, the metal circuit element 49 could be part of a read/write bus in a semiconductor memory chip and the metal element 50 be an extension to a selectable additional column of (redundant) memory cells. Alternatively, the circuit element 49 could be part of an output bus line in one semiconductor device and the element 50 part of an input bus line for a selectable device of a wafer level integrated circuit. It will be understood that the embodiment 20b may have many other applications.

In both FIGS. 6 and 7, the amorphous region 44 has been formed after the disposition and patterning of the metal layer 49 (and the metal layer 50). However, the amorphous region 44 could be formed prior to metal deposition with the option of an additional dielectric layer (not shon) between the amorphous region and the metal layer deposition.

FIG. 8 illustrates a still further embodiment of a semiconductor device 20c in which a first circuit element 51 and a second circuit element 53 are formed in the surface of a substrate 55 of a semiconductor wafer. A shallow link 59 formed of the same material as the circuit elements creates a conductive path joining the first circuit element 51 to the second circuit element 53. In the illustrated embodiment, the circuit elements 51,53 and the link 59 are formed of P+ type material and the substrate is of N type material. A conventional dielectric layer 61 of $SiO_2$ or other suitable material is formed on the wafer surface by conventional means such as chemical vapor deposition or thermal growth. The layer 61 covers the circuit elements 51,53 and the link 59. A conventional photoresist layer 63 is then formed on the wafer, and an opening 65 is formed above a portion of the link 59 to allow a window 67 to be etched through dielectric layer 61 to expose shallow link 59. The wafer is then subjected to an atom bombardment 69 which creates an amorphous region 71 penetrating through the entire depth of the link 59 and into the substrate 55 as illustrated by a dashed line 72. The amorphous region 71 is nonconductive and therefore electrically separates the first circuit element 51 from the second circuit element 53. The preferred implant for this embodiment is of nondoping ions such as silicon or argon. This prevents leakage conductivity around the edge of the amorphous region.

As explained previously with reference to FIGS. 3 to 5 above, the photoresist layer 63 is then removed and at least one dielectric layer 46, depending upon the wafer design, is deposited over the wafer covering the exposed amorphous region. A user may then selectively activate the amorphous region 71 by directing an energy beam 48 through the dielectric layer 46 onto the underlying amorphous region. The energy beam, as explained in more detail above, provides the energy which produces recrystallization of the amorphous region, making the link 59 once again conductive.

In the semiconductor devices described above, a user is able selectively to activate links joining a first circuit element to a second circuit element without destroying an overlying dielectric layer. The devices also have the advantage that there is no need to create undoped regions between the circuit elements. Circuit elements can therefore be tightly packed without danger of splatter or thermal damage when reconfiguring redundancy circuits, so design rules can be relaxed.

Means other than those described could be employed to form the amorphous region, as 44, and/or to recrystallize it. Additionally, one or both of the circuit elements contacted by the selectively actuatable conductive link could be silicide or polycrystalline silicon elements formed in the layers above the semiconductor substrate. It is also possible to utilize a processing sequence in which photoresist alone, rather than photoresist over a dielectric layer, defines the window for the ion beam implant to create the amorphous region.

**Claims**

1. A method of manufacturing a semiconductor device (20) having at least one selectively actuable conductive link, comprising the steps of:

forming circuit elements (22,24;49,50;51,53) on a semiconductor substrate (26;55);

forming an electrically conductive semiconductor link (34;59) joining at least one said circuit element to another said circuit element;

creating a non-conductive region (44;71) within said conducting link; and

selectively activating said non-conductive region with an energy beam (48) to electrically connect said circuit elements.

2. A method as claimed in claim 1, wherein a plurality of electrically conductive semiconductor links (34;59) are formed, each said link joining corresponding circuit elements (22,24;49,50;5l,53), and each said link including a respective selectively actuable non-conductive region (44;7l).

3. A method as claimed in claim l or 2, wherein the or each said semiconductor link (59) is formed in said semiconductor substrate (55).

4. A method as claimed in any preceding claim, wherein the or each said non-conductive region (44;7l) is formed by introducing neutral atoms into said link (34;59).

5. A method as claimed in any of claims l to 3, wherein the or each said semiconductor link (34;59) is doped, and wherein the or each said non-conductive region (44;7l) is formed by introducing ions of the same conductive type as the dopant into said link.

6. A method as claimed in any of claims l to 3, wherein the or each said semiconductor link (34;59) is doped, and wherein the or each said non-conductive region (44;7l) is formed by introducing ions of the opposite conductive type as the dopant into said link.

7. A method as claimed in any of claims 4, 5 or 6, wherein the or each said semiconductor link (34) is formed of doped polycrystalline silicon.

8. A method as claimed in any of claims l to 3, wherein the or each said semiconductor link (34) is formed of N+ doped polycrystalline silicon, and wherein the or each said non-conductive region (44) is formed by introducing ions of phosphorus or arsenic into said link.

9. A method as claimed in any of claims l to 3, wherein the or each said semiconductor link (34) is formed of P+ doped polycrystalline silicon, and wherein the or each said non-conductive region (44) is formed by introducing ions of boron, boron difluoride or phosphorus into said link.

l0. A method as claimed in any of claims 5 to 9, wherein said ions are introduced in a dose of l × l0$^{15}$ ions/cm$^2$, and said ions have an energy of 30 to 300 keV.

ll. A method as claimed in any of claims l to 4, wherein the or each said non-conductive region (44) is formed by introducing atoms of silicon or argon into the or each said semiconductor link.

l2. A method as claimed in any preceding claim, wherein said energy beam (48) is an electron beam.

l3. A method as claimed in any of claims l to ll, wherein said energy beam (48) is a laser.

l4. A method as claimed in claim l3, wherein said laser is a green light laser having an energy of 0.05 to l.0 J/cm$^2$.

l5. A method as claimed in any preceding claim, further comprsing the steps of forming an insulating layer (28) adjacent the circuit elements; and forming through holes (30) in said insulating layer to said circuit elements; wherein the link or links connect said circuit elements by way of said through holes (30).

l6. A method as claimed in any preceding claim, wherein a dielectric layer (28) is formed on said substrate (26), and at least one semiconductor link (34) is spaced above said substrate by said dielectric layer (28).

l7. A method as claimed in any preceding claim, wherein a dielectric layer (28) is formed on said substrate (26), and at least one circuit element (49;50) is spaced above said substrate by said dielectric layer (28).

l8. A semiconductor device having at least one selectively actuable link, comprising:

a semiconductor substrate (26;55);
circuit elements (22,24;49,50;5l,53) formed on said substrate;
a semiconductor link (34;59) joining at least one circuit element to another said circuit element; and
a non-conducting region (44;7l) within said semiconductor link;
wherein said non-conducting region can be selectively activated by way of an energy beam to thereby electrically connect said circuit elements.

l9. A semiconductor device as claimed in claim l8, further comprising at least one layer (36) of dielectric material deposited over the or each semiconductor link.

20. A semiconductor device as claimed in claim l8 or l9, wherein the or each said non-conducting region (44;7l) has been formed by the implantation of neutral atoms.

2l. A semiconductor device as claimed in claim 20, wherein the or each said non-conducting region has been formed by a dose of implanted atoms having an energy in the range of 30 to 300 keV, the dose being l × l0$^{15}$/cm$^2$.

22. A semiconductor device as claimed in claim 20 or 2l, wherein said implanted atoms are of silicon.

23. A semiconductor device as claimed in claim l8 or l9, wherein the or each said semiconductor link (34;59) is formed of doped polycrystalline silicon, and wherein the or each said non-conducting region (44;7l) has been formed by the implantation of ions of the same conductive type as the dopant in said doped polycrystalline silicon.

24. A semiconductor device as claimed in claim l8 or l9, wherein the or each said semiconductor link (34;59) is formed of a doped material, and wherein the or each said non-conducting region (44;7l) has been formed by the implantation of ions of an opposite conductive type to that of the initial dopant within said link or links.

25. A semiconductor device as claimed in any of claims l8 to 24, wherein the or each said semiconductor link is in said semiconductor substrate (26;55).

26. A semiconductor device as claimed in any of claims l8 to 25, wherein the or each said nonconducting region (44;7l) is substantially amorphous, and is arranged to be recrystallized at temperatures above about 600°C.

## FIG.1A.

## FIG.1B.

## FIG.1C.

## FIG.1D.

# FIG. 1E.

36  34

N+  22  28  26  24  P  N+

20

# FIG. 1F.

39

38  38  36

N+  22  34  28  24  P  N+

20

**FIG. 1G.**

**FIG. 2.**

**FIG. 3.**

FIG.4.

FIG.5.

FIG.8.

# FIG. 6.

49
46
36
44
36
34
28
34
24
26
P
N+
20a

# FIG. 7.

49
46
36
44
36
50
28
34
26
P
20b

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | IBM TECHNICAL DISCLOSURE BULLETIN, vol.21, no. 3, August 1978, page 1086, Armonk, New York, US; K. BRACK et al.: "Directed activation of implanted semiconductor zones" * Whole document * | 1,18 | H 01 L 21/90 H 01 L 23/52 // H 01 L 21/268 H 01 L 21/263 |
| A | Idem | 2,3,12, 13,25 | |
| | --- | | |
| Y | GB-A-2 100 057 (THE POST OFFICE) * Abstract; page 1, lines 35-76; page 1, line 128 - page 2, line 23 * | 1,18 | |
| A | | 12,13, 15,19 | |
| | --- | | |
| Y | EP-A-0 118 158 (PHILIPS) * Abstract; page 6, line 29 - page 7, line 30; figures 8,9 * | 1,18 | |
| A | | 2-5,10, 11,20, 21 | TECHNICAL FIELDS SEARCHED (Int. Cl.4) |
| | --- | | |
| A | PROCEEDINGS OF THE IEEE, vol. 60, no. 9, September 1972, pages 1062-1096, New York, US; J.F. GIBBONS: "Ion implantation in semiconductors-part II: damage production and annealing" * Page 1073, section III g "The production of amorphous material"; page 1087, section V b,c, "Annedling behavior of the damaged regions" and section V d, "Hot-implant studies"; table VII * | 4,5,8- 10,20- 22 | H 01 L |
| | ---       -/- | | |

The present search report has been drawn up for all claims

| Place of search | Date of completion of the search | Examiner |
|---|---|---|
| THE HAGUE | 08-12-1987 | MACHEK,J. |

European Patent Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A,D | IEEE TRANSACTIONS ON COMPONENTS, HYBRIDS, AND MANUFACTURING TECHNOLOGY, vol. CHMT-7, no. 4, December 1984, pages 438-442, New York, US; D.L. PARKER et al.: "Laser polysilicon link making" * Figures 1,2; page 439, left-hand column, line 16 - page 441, left-hand column, line 6; page 438, right-hand column, line 11 - page 439, line 15; figures 3,4,7 * | 1,7-9, 13-16, 18,19, 23,26 | |
| A | APPLIED PHYSICS LETTERS, vol. 48, no. 17, April 1986, pages 1132-1134, American Institute of Physics, Woodbury, New York, US; M. MIYAO et al.: "Electron irradiation-activated low-temperature annealing of phosphorus-implanted silicon" * Figure 1; page 1132, left-hand column, line 24 - page 1133, left-hand column, line 7 * | 1,3,6, 10,12, 18,21 | |
| A | JOURNAL OF VACUUM SCIENCE & TECHNOLOGY/A, vol. 3, no. 3, part 1, May-June 1985, pages 892-895, American Vacuum Society, Woodbury, New York, US; R. CHOW et al.: "Activation and redistribution of implanted P and B in polycrystalline Si by rapid thermal processing" * Page 892, section II, "experimental" * | 7-10,21 ,23-25 | |

TECHNICAL FIELDS SEARCHED (Int. Cl.4)

The present search report has been drawn up for all claims

| Place of search | Date of completion of the search | Examiner |
|---|---|---|
| THE HAGUE | 08-12-1987 | MACHEK,J. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
 
& : member of the same patent family, corresponding document

EPO FORM 1503 03.82 (P0401)